# EUROPEAN PATENT SPECIFICATION

(11) **EP 3 319 133 B1**
(45) Date of publication and mention of the grant of the patent: **20.09.2023**
(21) Application number: 16813778.4
(22) Date of filing: 20.05.2016
(51) Int. Cl.: H10N 30/30, H10N 39/00

(54) **SYSTEM AND DEVICE FOR COLLECTING PIEZOELECTRIC ENERGY**
SYSTEM UND VORRICHTUNG ZUM SAMMELN VON PIEZOELEKTRISCHER ENERGIE
SYSTÈME ET DISPOSITIF PIÉZOÉLECTRIQUE DE COLLECTE D'ÉNERGIE

(30) Priority: 24.06.2015 ES 201530896
(43) Date of publication of application: 09.05.2018
(73) Proprietor: Consejo Superior De Investigaciones Científicas, 28006 Madrid (ES)
(72) Inventor: MURILLO RODRIGUEZ, Gonzalo, 08193 Cerdanyola del Vallès (Barcelona) (ES); ESTEVE TINTO, Jaume, 08193 Cerdanyola del Vallès (Barcelona) (ES); SACRISTAN RIQUELME, Jorge, 08193 Cerdanyola del Vallès (Barcelona) (ES)
(74) Representative: Clarke, Modet y Cía., S.L.
(86) International application number: PCT/ES2016/070381
(87) International publication number: WO 2016/207458

(56) References cited:
- WO-A1-2012/158914
- US-A1- 2005 134 149
- US-A1- 2013 049 539
- FONSECA LUIS ET AL: "SiNERGY, a project on energy harvesting and microstorage empowered by Silicon technologies", 2015 10TH SPANISH CONFERENCE ON ELECTRON DEVICES (CDE), IEEE, 11 February 2015 (2015-02-11), pages 1-3, XP032764735, DOI: 10.1109/CDE.2015.7087488 [retrieved on 2015-04-16]
- FONSECA ET AL.: 'SiNERGY, a project on energy harvesting and microstorage empowered by Silicon technologies' 2015 10TH SPANISH CONFERENCE ON ELECTRON DEVICES (CDE, [Online] MADRID, pages 1 - 3, XP032764735 Retrieved from the Internet: <URL:http///ieeexplore.ieee.org/stamp/stamp .jsp?tp=&arnumber=7087488& insumber=7087435>
- MURILLO ET AL.: 'Novel optimized design of a piezoelectric energy harvester in a package for low amplitude vibrations' JOURNAL OF PHYSICS: CONFERENCE SERIES, [Online] vol. 476, 2013, page 012042, XP020254754 Retrieved from the Internet: <URL:http://stacks.iop.org/1742-6596/476/i= 1/a=012042>
- MURILLO ET AL.: 'Hybrid resonant energy harvester integrating ZnO NWs with MEMS for enabling zero- power wireless sensor nodes' NANO COMMUNICATION NETWORKS, [Online] vol. 2, no. ISSUE, December 2011, ISSN 1878-7789 pages 235 - 241, XP028105100 ISSN: 1878-7789 Retrieved from the Internet: <URL:http://dx.doi.org/10.1016/j.nancom. 2011.10.00 1>
- MURILLO ET AL.: 'Integration of piezoelectric energy scavengers with FBAR resonators for the miniaturization of autonomous wireless sensors nodes' MICRO ELECTRO MECHANICAL SYSTEMS (MEMS), 2012 IEEE 25TH INTERNATIONAL CONFERENCE, [Online] 29 January 2012, pages 1253 - 1256, XP032137260 Retrieved from the Internet: <URL:http://ieeexplore.ieee.org/stamp/stamp .isp?tp=&arnumber=617019S&isnumber=61 70071>

## Description

### Field of Invention

The present invention belongs to the field of electronics and, more specifically, to nanoscale piezoelectric devices for harvesting mechanical energy.

### State of the Art

There is a need for electrical generators that are capable of providing power with high impact resistance and quality factor.

Prior MEMS devices (MEMS stands for microelectromechanical systems) use standard AIN thin-film and have disadvantages of having a limited critical fracture stress and significant rigidity that make them not optimum for ambient vibration applications. Moreover, so far, they required external control and power management circuitry that makes difficult their integration and large scale manufacturing.

Recently, it was proposed an approach based on piezoelectric nanofibres. Nevertheless this prior device has several disadvantages: low fibre surface density, low integration capability, difficult to obtain a large number of aligned fibers, substrate contamination due to nitration/oxidation of fibres. In addition, it requires a complex technological development (electro-spinning). Also, this device is less compatible with VLSI (Very large Scale Integration) silicon technologies.

ZnO nanowires have being used as piezoelectric material in the last years, because they can be grown in an economic and easy way by hydrothermal method. Main application has been energy harvesting and sensors, but the devices have been mainly bulky macroscopic devices dedicated to generate as much power as possible. However, MEMS technology has not been exploited to successfully combine these nanostructures with micro-scale movable devices to target the small energy niche offered by ambient vibrations.

US20050134149A1 proposes a piezoelectric vibration harvesting device having a cymbal stack structure with a proof mass on top. This proposal is different to the present invention, in addition to its layout, in that the proposed invention uses ZnO nanostructures as main piezoelectric material instead of thin-films. In addition, the devices according to the invention can monolithically integrate diodes and capacitors.

L. Fonseca et al., "SiNERGY, a project on energy harvesting and microstorage empowered by Silicon technologies," 2015 10th Spanish Conference on Electron Devices (CDE), 2015, pp. 1-3, doi: 10.1 109/CDE.2015.7087488 discloses mechanical harvesters for the Internet of Things. In particular, a thermal and a piezoelectric harvester are discussed. The piezoelectric harvester includes an inertial mass micromachined in a Si die that can be coupled to secondary batteries to buffer energy in order to make autonomous wireless communication units.

US 2013/049539 A1 discloses an apparatus for harvesting piezoelectric vibration having a substrate with a groove and a piezoelectric MEMS cantilever with an end fixed to the substrate and with the other end floating above the groove. The apparatus also includes a capacitor and a rectifier. The capacitor reduces the ripple of voltage outputted from the rectifier. The rectifier may be composed of four or two diodes, following a full-bridge type or a half-bridge type configuration. The rectifier and the capacitor may be manufactured in advance or connected in an integrated circuit type.

### Brief description of the invention

The invention is devoted to develop a silicon-friendly family of piezoelectric nanostructured devices with integrated rectification and buffer charge-storage capacitor able to harvest energy from mechanical motions.

According to the invention, a piezoelectric energy harvesting device is proposed as defined in claim 1. It comprises an anchored part, an inertial mass and a movable flexible structure. The movable flexible structure comprises a silicon substrate and a piezoelectric layer with a plurality of nanostructures. A capacitor is formed between a bottom electrode of a highly doped region of the silicon substrate and a top electrode of a metal layer and a Schottky diode is formed between the said metal layer and a lightly doped region in the anchored part of the silicon substrate, the diode is in-series with the capacitor.

Preferably, the flexible structure is a cantilever beam between the anchored part and the inertial mass however other movable structures are possible. For instance, a clamped-clamped beam, a serpentine suspension, a membrane or other elastic element that can play the role of spring.

The cantilever beam is designed to bend, thereby causing the piezoelectric nanostructures to generate a piezopotential-driven current rectified by the diode and stored by the capacitor.

Preferably, a seed layer comprising Au is formed under the piezoelectric layer made of ZnO to grow nanowires as nanostructures. Preferably, the length of nanowires is from 100 nm to 10 µm.

Alternatively, a seed layer comprising AIN is formed under the piezoelectric layer made of ZnO to grow nanosheets as nanostructures. Preferably, the diameter of nanosheets ranges from 100 nm to 10 µm.

The electrodes of the capacitor may extend from the cantilever beam to the anchored part but, preferably they can be extended to cover the entire available die surface to maximize the capacitance value.

Preferably, the substrate material is n-type crystalline silicon.

Alternatively, the substrate material is p-type crystalline silicon.

According to the invention, an energy harvesting system is also proposed. The system comprises an array of piezoelectric energy harvesting devices, wherein neighboring devices are stacked by leaving a gap in between for the motion of the inertial mass.

Preferably, the energy harvesting devices are combined in-series.

Alternatively, the energy harvesting devices are combined in-parallel.

In sum, a new approach is proposed to produce piezoelectric MEMS energy harvesters also referred to as scavengers MEMS. The proposed devices are based on nanowires (NWs) and nanosheets (NSs) as piezoelectric material with a monolithically integrated diode and capacitor in a silicon-friendly technology.

In some embodiments ZnO is chosen as a low-cost solution to grow NWs and NSs by hydrothermal method. ZnO also provides a higher supported stress, enhanced flexibility and reduced manufacturing cost. At the same time, it is much easier to integrate with silicon than other nanostructure-based approaches. The device allows an out-of-plane motion when mechanically excited.

The proposed energy harvesting device contains a Schottky diode and capacitor monolithically integrated besides the piezoelectric nanogenerator which allow an in-situ signal rectification and buffer charge storage.

Positively, several energy harvesting devices can be combined to maximize the extracted power without concerns about AC output signal phases. The trade-off between size and number of energy harvesting devices shows that several smaller devices targeting different resonance frequencies can get higher generated power density than a bigger single unit with the same overall size.

The invention has further advantages: an overall higher flexibility and lower fracture risk, better performance and integrated rectification and storage. This combination of power output with reliability improves the known state of the art devices.

These and other aspects of the invention will become apparent from the drawings and exemplary embodiments.

### Brief description of the drawings

A series of drawings which aid in better understanding the invention and which are expressly related with embodiments of said invention, presented as a non-limiting example thereof, are very briefly described below.
**Figure 1****:** Functional device configuration. (Left) A cantilever structure for mechanical out-of-plane motions, with the two different ZnO nanostructures for piezoelectric transduction: nanowires (right-down) and nanosheets (right-up)
**Figure 2****:** Several views of ZnO nanowires. Figure 2a is an overall view. Figure 2b is a detailed view. Figure 2c shows a top view of nanosheets. Figure 2d shows a tilted view.
**Figure 3** is a cross section of the final device built on an SOI substrate.
**Figure 4** is an X-Ray Diffraction (XRD) measurement of ZnO nanosheets grown over an AIN seed layer.

### Detailed description

Several embodiments will be discussed for a better understanding of the invention.

As indicated before, one of the goals of this invention is to make the energy harvester robust enough, able to work in a reliable way under the imposed conditions. For this purpose, piezoelectric nanostructures, also known in general as nanogenerators (NGs), are adopted instead of thin-films.

The approach takes advantage of ZnO as transduction material to convert the mechanical energy coming from the input accelerations present in the environment for two different cases. Two types of ZnO nanostructures will be integrated to obtain usable devices: nanowires (NWs) and nanosheets (NSs).

Both NWs and NSs can be generated sharing almost the same fabrication process: These ZnO nanostructures have the particularities of using:
- the whole die surface to manufacture the storage capacitor,
- the top electrode of this capacitor as seed layer to grow the ZnO nanostructures on top of the cantilever to be bent, and
- a small undoped silicon die region are to monolithically integrate Schottky diodes.

### Device layout

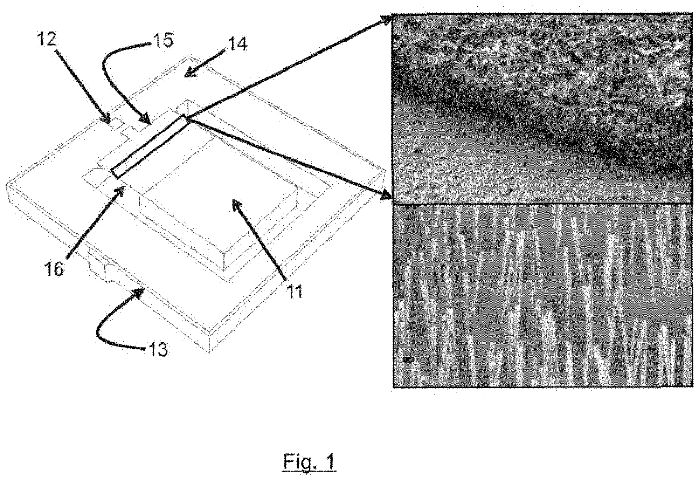

**Figure 1** shows the configuration of one of the final devices. The common configuration of the different design versions is based on a cantilever architecture, because current silicon-based piezoelectric harvesters show the best performance with a spring-mass system. However, other suspensions, such as clamped-clamped beams, serpentine flexures, membranes or other elastic elements can be used instead of cantilever beam.

Inertial mass **11** is connected through a cantilever beam **16** to the rest of the device die **13.** On top of this cantilever, there is a piezoelectric layer **15** made of ZnO nanostructures. Monolithically integrated in the same die **13,** there is a Schottky diode **12** and a capacitor **14.**

Several sizes will be generated to get different resonance frequencies, and combined to obtain multifrequency arrays of energy harvesters. The typical lateral dimensions of the cantilevers and inertial mass will range from 0.5 to 5 mm, and the target thickness of the piezoelectric layer will be around 1 µm for the first prototype. The harvesters can be combined to produce an array according to series or parallel combination of them. Depending on this electrical combination, increment of output current or voltage levels will be obtained for series and parallel combinations respectively. In order to physically combine the devices, they can be stacked by leaving enough space in between for the inertial mass resonant motion.

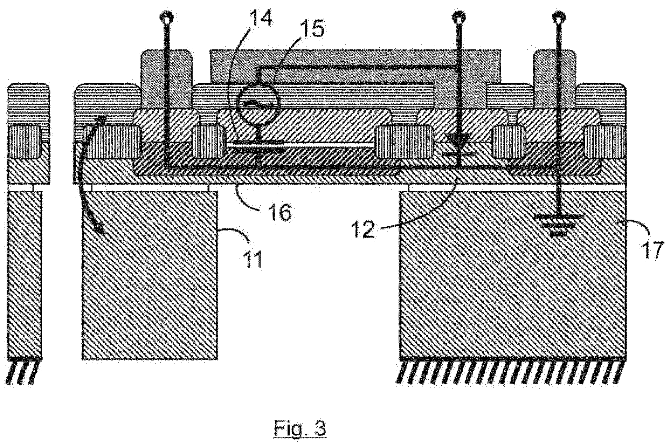

As illustrated in **Figure 3****,** the spring is built by means of silicon beams microstructured on the SOI device layer and covered by the different piezoelectric material that plays the role of mechanical spring and transductor. The inertial mass **11** is created by etching both top and bottom silicon layer of the SOI (Silicon On Insulator) wafer by RIE (Reactive Ion Etching) and DRIE (Deep Reactive Ion Etching) respectively. The non-etched part which corresponds to the frame off the die that will form the anchored part **17.**

The use of an SOI wafer, eases the definition of cantilever beam **16** and the inertial mass **11.** This wafer will be n-type in order to be able of integrating a Schottky diode **12** and a capacitor **14** together with the movable structure. The diode **12** will have the role of rectifying, with low losses, the AC signal generated by the NGs which at the same time will be grown just on top of the large surface of the capacitor **14** to save area.

This configuration creates a network of a diode **12,** piezoelectric AC layer **15** as generator and a capacitor **14** in series, therefore for each mechanical stimulation on the NGs, negative charges will be stored in the capacitor **14.** Due to the in-situ rectification, different designs with different sizes can be connected together and the voltage output will be always added. For instance, longer cantilever **13** and/or bigger inertial masses **11** will result on lower resonance frequencies and thicker beams and/or stiffer materials will increases the resonance frequencies.

### Materials

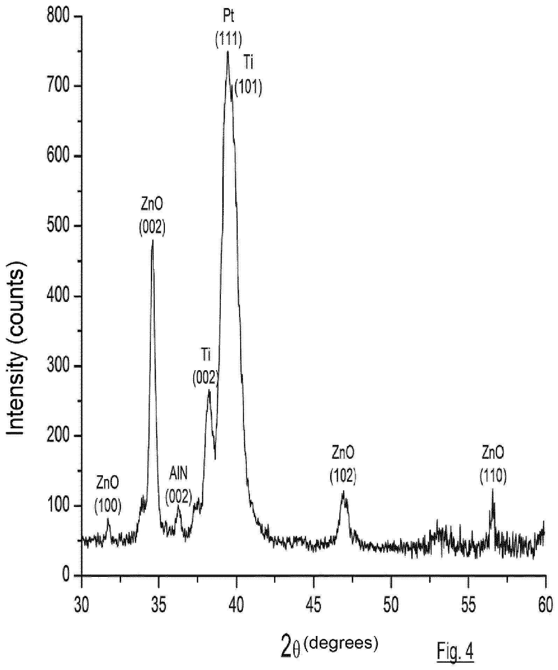

These devices use an SOI wafer as main structural part. The substrate is chosen in order to facilitate the inertial mass and beam definitions. Then two different piezoelectric materials are used:
**AlN:** This piezoelectric material has been used for several years to fabricate FBARs (Film Bulk Acustic-wave Resonator) and energy scavengers. AIN is used as seed layer to grow ZnO NSs which will conform a functional nanostructured piezoelectric layer. AIN is processed by RF sputtering on top of a thin layer of Ti/Pt which infers a good crystalline orientation. Thin layers of less than 100 nm can be deposited and XRD analysis of **Figure 4** shows that the crystalline structure and orientation are stable. The final thicknesses used in this type of devices may be between 10 nm and 1 um.
**ZnO:** This piezoelectric and semiconductor material will be used to grow nanostructures, specifically on piezoelectric ZnO nanowires (NWs) and nanosheets (NSs). ZnO NGs have been used for energy harvesting in the last years. These nanostructures have the advantages of being more flexible, less sensitive to fracture, and can be actuated easier than thin-films. The growth method is based on a hydrothermal chemical reaction at low temperature (< 80° C) directly on the silicon substrate covered by a seed layer. This growth method is especially fast, easy, inexpensive and fully compatible with wafer-level silicon-based microelectronics technologies.

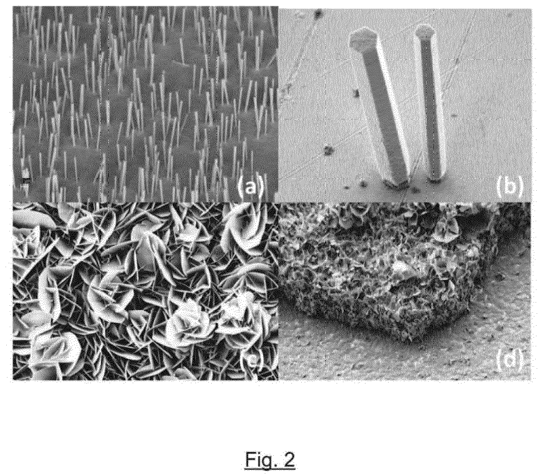

**Figure 2** shows the two types of ZnO nanostructures that will be used to fabricate the devices.

For the case of NSs, a thin layer of AIN (thickness can be smaller than <100nm) is used as seed layer, anti-screening carrier barrier and additional piezoelectric material. In this way, the thin layer of AIN should not affect the mechanical properties of the device because the created stress scales down with the thickness. The growth method for ZnO NSs is the same as for the NWs, but a different seed layer is used totally affecting the grown nanostructure shape. The main point that makes this nanostructure a promising solution for NG is the high uniformity, reproducibility and rapidness of the NS growth.

Several studies have been carried out in order to verify that ZnO NSs grown over AIN have a good crystallinity and therefore piezoelectric properties.

A XRD study was also performed to observe other crystalline orientations present in a matrix of NSs. The result can be seen in **Figure 4****.** An outstanding peak can be observed for the desired (002) orientation of the ZnO, also the contribution of the AIN thin film is clearly visible.

### Process flow

As already mentioned, a capacitor and a diode will be integrated together with the energy harvester in order to have a compact system able to get a DC voltage from a variable input acceleration. The fabrication process is addressed to be compatible with low demanding CMOS technologies.

The process steps to be followed to carry out the technological fabrication, including seven photolithographic steps, are listed below:
1. An n+ implantation is performed in selected areas of the n-doped SOI device layer through a protection oxide previously grown. This implantation will define the Ohmic contact with silicon and the bottom electrode of the capacitor. (N+ mask)
2. A field oxidation of 1060 nm is carried out in order to passivate the different devices. By means of Reactive Ion Etching (RIE) and wet etch this oxide can be selectively removed to define active regions. (Active area mask)
3. Performing of gate oxidation of 365 Å at 950 °C to create the thin oxide layer needed to make the capacitor.
4. Removing this thin oxide through dry and wet etches from contact areas to allow electrical access to the different contacts. (Contact mask)
5. On top of these contact areas, a multilayer of Cr/Ni/Au will be sputtered to create the capacitor top electrode, the metal-semiconductor interface of the Schottky diode and the metallic contacts. The capacitor electrode can be designed to cover the entire available die surface to maximize its charge capacity which is a great improvement compared to state-of-the-art devices. The last exposed Au layer will be also used as seed layer to grow ZnO NWs.
6. In order to fabricate the version of this device based on ZnO NS, a Ti/Pt layer followed by an AIN layer of 100 nm will be deposited by RF sputtering to generate the seed layer for these nanostructures.
7. The total metal stack and seed layer when applicable, is etched afterwards in selected areas. (Metal1 mask)
8. ZnO nanowires and nanosheets will be grown by a hydrothermal process on the respective seed layers deposited over capacitor top electrode which makes this device unique.
9. A layer of polymer (e.g. PMMA, PDMS or SU8), will be spin coated over the surface and developed to embed the NWs/NSs to avoid short-circuits between NG electrodes, if needed.
10. A thick layer of aluminum will be deposited (also other metals such as titanium and platinum can be used), patterned and etched to cover the embedded NWs/NSs, creating the upper NG electrode. (Metal2 mask).
11. The outline of the movable structures is patterned on the device side (RIE-front mask) and the SOI device layer is etched through by RIE.
12. On the back side, aluminum is deposited, patterned and etched to create a hard-mask for the DRIE. (DRIE-back mask).
13. The SOI handle wafer is fully etched by DRIE down to the buried oxide. A protective resist is coated on the front side before performing this step.
14. The structures are carefully released by wet etching of the SiO₂ and the resist coating is dissolved by acetone immersion.

The final device is a released tip-loaded piezoelectric cantilever beam with integrated capacitor and diode as shown in **Figure 3****.** This integration allows reduced power losses and eases the combination of several generators without the need of controlling the phase differences of the generated piezopotentials (i.e. no resonant motion synchronization is necessary).

### Performance

For the device based on ZnO NWs, we take the assumption that the density of NWs will be ~4 NW/µm². If every NW takes an active part in the charge generation, and from a value of 4 pW/NW measured when a NW is bent by an AFM tip, it can be estimate a generated power of ~1.6 mW/cm². However, in our case the mechanical stimulation will be produced by the compression of the NW arrays derived from the beam bending and a typical transduction surface of 1 mm². A power output of 1.45 mW/cm² (for transduction area of ~4 mm²) has been reported for a structure similar to the one which will be placed on top of the integrated capacitor for pressure levels similar to the achieved with the cantilever beam bending. Taking into account our device configuration (transduction area of ~1 mm², acceleration of 1-10 g, main stress of 1-10 MPa), a target output power of 500 µW/cm² is a reasonable value. For the case of NSs, no previous data is available, but comparable power densities are expected because of the similar dimensions and crystal configuration of both NWs and NSs.

From previous results, obtained by using similar structures but with a thin-film approach, we can estimate a lower limit value for our prototypes.

For the first prototype, the dimensions of the final devices will be 0.5x0.5x0.05 cm³, and they will be based on an n-type SOI wafer. A frame or holder made of glass or silicon is expected to be used in order to allow the inertial mass to move up and down. This support frame could increase the thickness of the final device by 0.05 cm.

### NUMERALS

11 Inertial mass.
12 Schottky diode.
13 Device die.
14 Capacitor.
15 Piezoelectric layer.
16 Cantilever beam.
17 Anchored part.

## Claims

1. A piezoelectric energy harvesting device, comprising:
- an anchored part (17);
- an inertial mass (11); and
- a movable flexible structure comprising a silicon substrate and a piezoelectric layer (15) with a plurality of nanostructures;
**characterised in that** the movable flexible structure further comprises:
- a capacitor (14) formed between a bottom electrode of a heavily doped region of the silicon substrate and a top electrode of a metal layer; and
- a Schottky diode (12) formed between said metal layer and a lightly doped region in the anchored part (17) of the silicon substrate, the diode (12) being in-series with the capacitor (14), wherein the movable flexible structure is configured to bend, thereby causing the piezoelectric nanostructures to generate a piezopotential-driven current rectified by the diode (12) and stored by the capacitor (14).

2. The device according to claim 1, wherein the movable flexible structure is a cantilever beam (16) between the anchored part (17) and the inertial mass (11).

3. The device according to claim 2, wherein a seed layer comprising Au is formed under the piezoelectric layer (15) made of ZnO, and wherein the nanostructures are nanowires.

4. The device according to claim 3, wherein the length of the nanowires is from 100 nm to 10 µm.

5. The device according to claim 1 or 2, wherein the movable flexible structure comprises a seed layer for growing the nanostructures, the seed layer being deposited over the top electrode of the capacitor (14).

6. The device according to claim 5, wherein the seed layer comprises AIN and is formed under the piezoelectric layer (15) made of ZnO, and wherein the nanostructures are nanosheets.

7. The device according to claim 6, wherein the diameter of nanosheets ranges from 100 nm to 10 µm.

8. The device according to any of claims, wherein the electrodes of the capacitor (14) extend from the movable flexible structure to the anchored part (17).

9. The device according to any of claims, wherein the substrate material is n-type crystalline silicon.

10. The device according to any of claims 1 to 8, wherein the substrate material is p-type crystalline silicon.

11. An energy harvesting system comprising an array of piezoelectric energy harvesting devices according to any of claims 1 to 10, wherein neighboring devices are stacked by leaving a gap in between for the motion of the inertial mass (11).

12. The system according to claim 11, wherein the energy harvesting devices are combined in-series.

13. The system according to claim 11, wherein the energy harvesting devices are combined in-parallel.

## Patentansprüche

1. Piezoelektrische Energiegewinnungsvorrichtung, die Folgendes umfasst:
- ein verankertes Teil (17);
- eine Trägheitsmasse (11); und
- eine bewegliche flexible Struktur, die ein Siliziumsubstrat und eine piezoelektrische Schicht (15) mit einer Vielzahl von Nanostrukturen umfasst;
**dadurch gekennzeichnet, dass** die bewegliche flexible Struktur ferner Folgendes umfasst:
- einen Kondensator (14), der zwischen einer unteren Elektrode einer stark dotierten Region des Siliziumsubstrats und einer oberen Elektrode einer Metallschicht gebildet ist; und
- eine Schottky-Diode (12), die zwischen der Metallschicht und einer leicht dotierten Region in dem verankerten Teil (17) des Siliziumsubstrats ausgebildet ist, wobei die Diode (12) in Reihe mit dem Kondensator (14) liegt, wobei die bewegliche flexible Struktur so ausgebildet ist, dass sie sich biegt, wodurch die piezoelektrischen Nanostrukturen veranlasst werden, einen piezopotenzialgetriebenen Strom zu erzeugen, der von der Diode (12) gleichgerichtet und von dem Kondensator (14) gespeichert wird.

2. Vorrichtung nach Anspruch 1, wobei die bewegliche flexible Struktur ein freitragender Träger (16) zwischen dem verankerten Teil (17) und der Trägheitsmasse (11) ist.

3. Vorrichtung nach Anspruch 2, wobei unter der piezoelektrischen Schicht (15) aus ZnO eine Au umfassende Saatschicht gebildet wird, und wobei die Nanostrukturen Nanodrähte sind.

4. Vorrichtung nach Anspruch 3, wobei die Länge der Nanodrähte im Bereich von 100 nm bis 10 µm liegt.

5. Vorrichtung nach Anspruch 1 oder 2, wobei die bewegliche flexible Struktur eine Saatschicht zum Aufwachsen der Nanostrukturen umfasst, wobei die Saatschicht über der oberen Elektrode des Kondensators (14) abgeschieden wird.

6. Vorrichtung nach Anspruch 5, wobei die Saatschicht AIN umfasst und unter der piezoelektrischen Schicht (15) aus ZnO gebildet wird, und wobei die Nanostrukturen Nanoblätter sind.

7. Vorrichtung nach Anspruch 6, wobei der Durchmesser der Nanoblätter im Bereich von 100 nm bis 10 µm liegt.

8. Vorrichtung nach einem der Ansprüche, wobei sich die Elektroden des Kondensators (14) von der beweglichen flexiblen Struktur zu dem verankerten Teil (17) erstrecken.

9. Vorrichtung nach einem der Ansprüche, wobei das Material des Substrats kristallines Silizium vom n-Typ ist.

10. Vorrichtung nach einem der Ansprüche 1 bis 8, wobei das Material des Substrats kristallines Silizium vom p-Typ ist.

11. Energiegewinnungssystem, das eine Anordnung von piezoelektrischen Energiegewinnungsvorrichtungen nach einem der Ansprüche 1 bis 10 umfasst, wobei benachbarte Vorrichtungen so gestapelt sind, dass ein Zwischenraum für die Bewegung der Trägheitsmasse (11) dazwischen verbleibt.

12. System nach Anspruch 11, wobei die Energiegewinnungsvorrichtungen in Reihe geschaltet sind.

13. System nach Anspruch 11, wobei die Energiegewinnungsvorrichtungen parallel geschaltet sind.

## Revendications

1. Dispositif piézoélectrique de collecte d'énergie, comprenant :
- une partie fixée (17) ;
- une masse inertielle (11) ; et
- une structure flexible mobile comprenant un substrat en silicium et une couche piézoélectrique (15) avec une pluralité de nanostructures ;
**caractérisé en ce que** la structure flexible mobile comprend en outre :
- un condensateur (14) formé entre une électrode inférieure d'une région fortement dopée du substrat en silicium et une électrode supérieure d'une couche de métal ; et
- une diode Schottky (12) formée entre ladite couche de métal et une région légèrement dopée dans la partie fixée (17) du substrat en silicium, la diode (12) étant en série avec le condensateur (14), dans lequel la structure flexible mobile est configurée pour se plier, amenant ainsi les nanostructures piézoélectriques à générer un courant induit par potentiel piézoélectrique rectifié par la diode (12) et stocké par le condensateur (14).

2. Dispositif selon la revendication 1, dans lequel la structure flexible mobile est une poutre en porte-à-faux (16) entre la partie fixée (17) et la masse inertielle (11).

3. Dispositif selon la revendication 2, dans lequel une couche de germe comprenant de l'Au est formée sous la couche piézoélectrique (15) réalisée en ZnO, et dans lequel les nanostructures sont des nanofils.

4. Dispositif selon la revendication 3, dans lequel la longueur des nanofils est de 100 nm jusqu'à 10 µm.

5. Dispositif selon la revendication 1 ou 2, dans lequel la structure flexible mobile comprend une couche de germe pour la croissance des nanostructures, la couche de germe étant déposée sur l'électrode supérieure du condensateur (14).

6. Dispositif selon la revendication 5, dans lequel la couche de germe comprend de l'AIN et est formée sous la couche piézoélectrique (15) réalisée en ZnO, et dans lequel les nanostructures sont des nanofeuilles.

7. Dispositif selon la revendication 6, dans lequel le diamètre des nanofeuilles est compris entre 100 nm et 10 µm.

8. Dispositif selon l'une quelconque des revendications, dans lequel les électrodes du condensateur (14) s'étendent depuis la structure flexible mobile jusqu'à la partie fixée (17).

9. Dispositif selon l'une quelconque des revendications, dans lequel le matériau de substrat est du silicium cristallin de type n.

10. Dispositif selon l'une quelconque des revendications 1 à 8, dans lequel le matériau de substrat est du silicium cristallin de type p.

11. Système de collecte d'énergie comprenant un réseau de dispositifs piézoélectrique de collecte d'énergie selon l'une quelconque des revendications 1 à 10, dans lequel les dispositifs attenants sont empilés en laissant un espace entre eux pour le mouvement de la masse inertielle (11).

12. Système selon la revendication 11, dans lequel les dispositifs de collecte d'énergie sont combinés en série.

13. Système selon la revendication 11, dans lequel les dispositifs de collecte d'énergie sont combines en parallèle.
